# DEMANDE DE BREVET EUROPEEN

(11) **EP 1 748 561 A1**
(43) Date de publication de la demande: **31.01.2007**
(21) Numéro de dépôt: 05405453.1
(22) Date de dépôt: 25.07.2005
(51) Int. Cl.: H03L 1/02

(54) **Procédé de thermocompensation d'une base de temps à quartz**

(71) Demandeur: Jaquet Ingénieur Conseils Sàrl, 2325 Les Joux-Derrière (CH); Logma SA, 3500 Le Locle (CH)
(72) Inventeur: Jaquet, Claude-Eric, 2325 Les Joux-Derrière (CH); Peguiron, Nicolas, 2400 Le Locle (CH)

(57) **Abrégé**

Pour compenser en température une base de temps à quartz, on associe sur un circuit électronique (1) un oscillateur à quartz (2) dont la caractéristique fréquence-température est parabolique ou cubique et un senseur de température (4) dont la dépendance en température est linéaire. Par calibration, on détermine à 3 ou 4 températures distinctes les valeurs de la correction à effectuer obtenues par comparaison avec un signal de référence qu'on associe aux valeurs du senseur de température converties par un convertisseur analogique-numérique (5); on mémorise ces 3 ou 4 couples de valeurs dans une mémoire non-volatile (6). Lors de l'utilisation, un circuit de correction (7) utilise les couples de valeurs ainsi mémorisés pour calculer, au moyen d'un polynôme du second ou du troisième degré, la valeur de correction à appliquer pour toute valeur produite par le senseur de température afin de produire un signal corrigé de fréquence indépendante de la température.

## Description

La présente invention concerne le domaine des bases de temps électroniques à quartz, destinées à produire un signal composé d'un nombre régulier d'impulsions par unité de temps, et plus précisément les bases de temps du genre mentionné ci-dessus dotées d'un dispositif permettant de compenser la dépendance en température de la fréquence d'oscillation du quartz.

L'on connaît déjà divers procédés pour corriger ou compenser la dépendance en température de la fréquence d'oscillation du quartz. Ces procédés se basent sur la forme connue de la caractéristique fréquence/température du quartz, qui peut être quadratique (parabolique) ou cubique par exemple; un élément sensible à la température (senseur de température), disposé près du quartz, fournit un signal qui, combiné avec ladite caractéristique connue, est utilisé pour corriger le signal produit par la base de temps.

L'inconvénient des procédés de compensation existants réside dans la nécessité de connaître le plus précisément possible la caractéristique fréquence/température du type de quartz utilisé ainsi que la dépendance en température du signal produit par le type de senseur de température utilisé. Dans la pratique, la connaissance de ces données est inévitablement entachée d'une dispersion d'un élément à l'autre, qui diminue la précision avec laquelle la correction peut être effectuée.

Le but de la présente invention est de fournir un procédé de compensation de la dépendance en température qui ne nécessite de connaissance ou de mesure préalables ni de la caractéristique fréquence/température du quartz, ni de la dépendance en température du senseur. Le procédé met en oeuvre la mise en mémoire de la signature individuelle constituée par la dépendance de la fréquence de l'oscillateur à quartz en fonction du signal produit par le senseur de température, déterminée lors d'une opération de calibration individuelle. En particulier, la présente invention apporte les avantages suivants :
- Le procédé est applicable aux quartz de caractéristique quadratique et cubique. Il n'est pas nécessaire de connaître la fréquence centrale ni l'ouverture de la parabole des quartz ayant une dépendance quadratique en température, par exemple.
- Le senseur de température n'a pas besoin d'être précis. Sa dépendance en température doit être linéaire; elle peut être positive (PTC) ou négative (NTC).
- La précision de la compensation effectuée ne dépend que de la reproductibilité du senseur de température et du vieillissement du quartz. Un senseur de température dont on n'attend qu'une bonne reproductibilité sans exigence de précision peut être bon marché; il peut aussi plus facilement être incorporé dans un circuit intégré. Le vieillissement des quartz est aujourd'hui bien maîtrisé. La précision de la compensation en température peut être encore accrue en utilisant des quartz pré-vieillis.
- Le réglage de la base de temps (ajustement de la précision) est inclus dans le procédé de compensation.
- Lors de la procédure de calibration, il n'est pas nécessaire de mesurer la température avec précision.

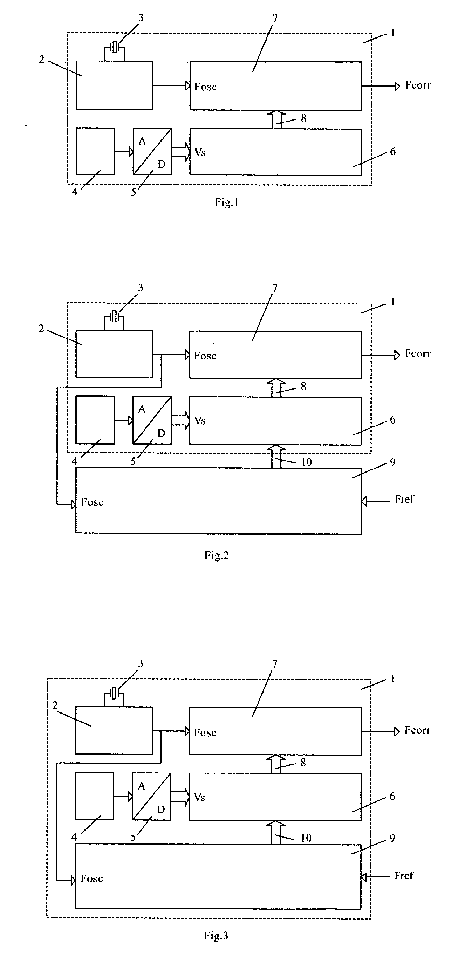

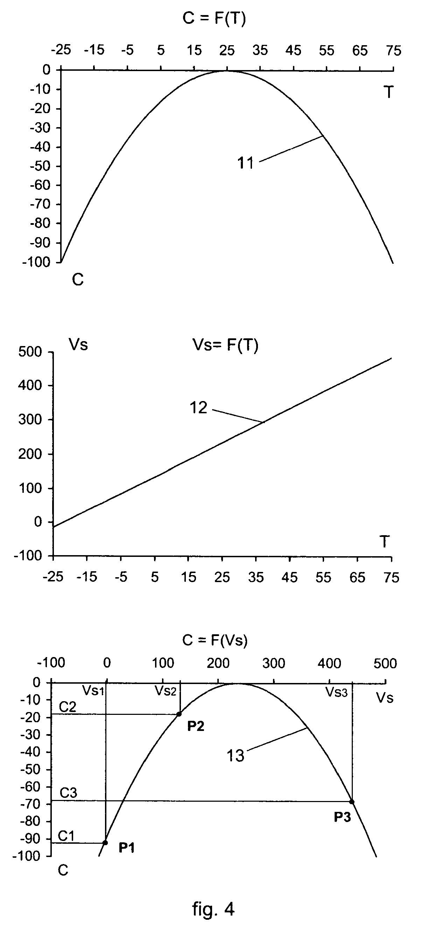

La Figure 1 illustre un exemple de réalisation de la présente invention. La base de temps (1) est composée d'un oscillateur (2) à quartz (3) produisant un signal de fréquence non compensée Fosc, d'un senseur de température (4) produisant un signal dépendant de la température, d'un convertisseur analogique-numérique (5) produisant une valeur Vs proportionnelle au signal produit par ledit senseur de température, d'une mémoire non volatile (6) et d'un circuit numérique (7) produisant un signal Fcorr dont la fréquence est compensée en température.

La base de temps doit être calibrée avant utilisation. La calibration peut avoir lieu une seule fois lors de la fabrication du produit; elle peut aussi être refaite ultérieurement, à intervalles réguliers ou irréguliers, durant la vie du produit. La Figure 2 illustre la procédure de calibration, dans laquelle un appareil de test (9) compare la fréquence non compensée Fosc produite par l'oscillateur (2) avec un signal de référence Fref de fréquence connue avec précision et calcule une information de correction à enregistrer dans la mémoire non volatile (6). L'opération est conduite à plusieurs températures distinctes couvrant la plage de températures de service de la base de temps. Pour les quartz dont la caractéristique fréquence-température est parabolique, l'opération de calibration doit être effectuée à trois températures distinctes; pour les quartz dont la caractéristique fréquence-température est cubique, l'opération de calibration doit être effectuée à quatre températures distinctes. A chaque température de calibration, l'information de correction (10) et la valeur Vs produite par le senseur de température (4) convertie par le convertisseur analogique-numérique (5) sont enregistrées de façon associées dans la mémoire non-volatile (6). La température de calibration elle-même n'a donc pas à être mesurées avec précision. Il suffit que les trois ou les quatre températures de calibration couvrent la plage de service de la base de temps et soient bien distinctes les unes des autres.

La figure 4 présente :
- un exemple (11) de caractéristique fréquence-température parabolique d'un oscillateur à quartz,
- un exemple (12) de dépendance en température de la valeur Vs produite par le senseur de température et convertie par le convertisseur analogique-numérique,
- l'exemple correspondant (13) de signature du couple formé par l'oscillateur à quartz et le senseur de température. Cette signature est de forme parabolique et est entièrement déterminée par les trois points de calibration P1, P2 et P3. De façon analogue, une caractéristique cubique (non représentée) est entièrement déterminée par quatre points de calibration.

Dans la présente invention, l'opération de calibration ignore les caractéristiques (11) et (12); elle n'enregistre dans la mémoire non volatile (6) que les trois couples de valeurs Vs1, C1, Vs2, C2 et Vs3, C3 représentant les trois points P1, P2 et P3 qui permettant de reconstituer la signature (13) et de calculer, au moyen d'un polynôme mathématique du second degré, la valeur de correction C correspondant à toute valeur de Vs. Dans le cas d'un quartz possédant une caractéristique fréquence-température cubique, quatre couples de valeurs doivent être mémorisés pour pouvoir reconstituer la signature (13) et calculer, au moyen d'un polynôme mathématique du troisième degré, la valeur de correction C correspondant à toute valeur de Vs.

Lors de l'utilisation de la base de temps (1), le circuit de correction (7) utilise les trois ou les quatre couples de valeurs Vs1, C1, Vs2, C2, etc. enregistrés aux différentes températures de calibration pour calculer, au moyen d'un polynôme du second ou du troisième degré, une valeur de correction C en fonction du signal Vs produit par le senseur de température (4) et convertie par le convertisseur analogique-numérique (5) et corriger la fréquence du signal Fosc produit par l'oscillateur (2) pour produire un signal Fcorr dont la fréquence est compensée en température. Il existe plusieurs méthodes connues pour effectuer cette correction, qui peut avoir lieu, par exemple, de façon numérique par inhibition (brevet n° CH 534.913/US 3.895.486).

## Revendications

1. Procédé de thermocompensation d'une base de temps à quartz, comprenant un quartz possédant une caractéristique fréquence-température parabolique (du second degré) ou cubique (du troisième degré) et un senseur de température produisant un signal électrique Vs dépendant linéairement de sa température, **caractérisé par** une opération de calibration consistant à placer ladite base de temps successivement à trois températures distinctes T1, T2 et T3 respectivement quatre températures distinctes T1, T2, T3 et T4, à mémoriser les trois couples de valeurs Vs1, C1, Vs2, C2 et Vs3, C3, respectivement les quatre couples de valeurs Vs1, C1, Vs2, C2, Vs3, C3 et Vs4, C4, les valeurs Vs1, Vs2 et Vs3, respectivement Vs1, Vs2, Vs3 et Vs4 étant obtenues par la mesure dudit signal électrique Vs produit par ledit senseur de température auxdites trois, respectivement quatre températures, les valeurs C1, C2 et C3, respectivement C1, C2, C3 et C4, étant obtenues en comparant auxdites trois, respectivement quatre températures la fréquence du signal Fosc produit par ledit oscillateur avec un signal de référence Fref dont la fréquence est connue, précise et stable, et par l'utilisation de ces trois, respectivement quatre couples de valeurs pour calculer en permanence au moyen de l'expression mathématique du polynôme du second degré, respectivement du troisième degré, pour toute valeur courante dudit signal électrique Vs produit par ledit senseur de température, la correction C à appliquer à la fréquence du signal Fosc produit par ledit oscillateur à quartz afin de produire un signal corrigé Fcorr dont la fréquence est proportionnelle à ladite fréquence de référence Fref et indépendante de la température.

2. Dispositif pour la mise en oeuvre du procédé décrit par la revendication 1 destiné à produire un signal corrigé Fcorr dont la fréquence est indépendante de la température, **caractérisé par** : un circuit électronique principal comprenant un oscillateur à quartz utilisant un quartz possédant une caractéristique fréquence-température parabolique (du second degré), ou cubique (du troisième degré), un senseur de température produisant un signal électrique Vs dépendant linéairement de sa température, un convertisseur analogique-numérique produisant une valeur numérique correspondant au signal produit par ledit senseur de température, une mémoire non-volatile pour mémoriser les trois, respectivement quatre couples de valeurs décrits dans la revendication 1, et un circuit numérique pour effectuer la correction de la fréquence du signal Fosc produit par ledit oscillateur à quartz en fonction de la valeur courante du signal électrique Vs produit par ledit senseur de température, convertie en une valeur numérique par ledit convertisseur analogique-numérique, calculée au moyen desdits trois, respectivement quatre couples de valeurs mémorisées, et par un circuit électronique auxiliaire qui compare le signal Fosc produit par l'oscillateur à quartz avec un signal de référence Fref dont la fréquence est connue, précise et stable, et détermine les valeurs de correction C1, C2 et C3 obtenues aux trois températures de calibration T1, T2 et T3, respectivement les valeurs de correction C1, C2, C3 et C4 obtenues aux quatre températures de calibration T1, T2, T3 et T4 qui, associées aux valeurs correspondantes Vs1, Vs2 et Vs3, respectivement Vs1, Vs2, Vs3 et Vs4 du signal produit par le senseur de température auxdites trois, respectivement quatre températures de calibration, forment les trois, respectivement quatre couples de valeurs à enregistrer dans la mémoire non-volatile.

3. Dispositif selon la revendication 2, **caractérisé par** le fait de réaliser le circuit électronique principal et le circuit électronique auxiliaire dans deux appareils distincts.

4. Dispositif selon la revendication 2, **caractérisé par** le fait de réaliser le circuit électronique principal et le circuit électronique auxiliaire dans un seul appareil.

5. Dispositif selon la revendication 2, **caractérisé par** la réalisation du senseur de température à réponse linéaire au moyen d'un circuit intégré.

6. Dispositif selon la revendication 2, **caractérisé par** le fait de placer le senseur de température et le quartz dans une même enceinte isolée thermiquement du milieu ambiant afin de garantir que les températures dudit quartz et dudit senseur restent très proches l'une de l'autre.
